# EUROPÄISCHE PATENTANMELDUNG

(11) **EP 0 780 690 A2**
(43) Veröffentlichungstag der Anmeldung: **25.06.1997**
(21) Anmeldenummer: 96250297.7
(22) Anmeldetag: 20.12.1996
(51) Int. Cl.: G01R 1/07

(54) **Sensor zur Feldstärkemessung**

(30) Priorität: 21.12.1995 DE 19549242
(71) Anmelder: Euro EMC Service Dr. Hansen GmbH, 14513 Teltow (DE)
(72) Erfinder: Hansen, Diethard, Dr.-Ing., 8965 Berikon 2 (CH); Ristau, Detlef, Dr.-Ing.habil., 12435 Berlin (DE); Schreiber, Thomas, Dr.-Ing., 12277 Berlin (DE); Roth, Eva, Dipl.-Ing., 12105 Berlin (DE)
(74) Vertreter: Hengelhaupt, Jürgen, Dipl.-Ing.

(57) **Zusammenfassung**

Die Erfindung beschreibt einen Sensor zur Feldstärkemessung von magnetischen und/oder elektrischen Feldern nach dem Superhet-Prinzip und ist anwendbar zur gleichzeitigen Erfassung dieser Feldkomponenten sowie der Bestimmung des Poynting-Vectors.
Der Sensor (1) besteht hierzu aus einem Meßkopf (2) und einem Elektronik- und Energieversorgungsblock (3) wobei der Meßkopf (2) als ein auf der Spitze (4a) stehender Würfel (4) ausgebildet ist und an allen Würfelflächen Leitungen (5) derart angeordnet sind, daß die an den sich gegenüberliegenden Würfelflächen angeordneten Leitungen (5) jeweils ein Paar bilden.

## Beschreibung

Die Erfindung betrifft einen Sensor zur Feldstärkemessung von magnetischen und/oder elektrischen Feldern und dient der gleichzeitigen Erfassung der elektrischen und magnetischen Felder sowie der Bestimmung des Poynting-Vectors.

Die Erfassung, Messung und Auswertung der Feldstärken von elektrischen und magnetischen Feldern gewinnt zunehmend an Bedeutung sowohl aus technischer, normativer, gesetzlicher, als auch aus biologischer und medizinischer Sicht.

Aus dem Stand der Technik sind bereits eine Reihe von Sensoren und Verfahren zur Messung dieser magnetischen bzw. elektrischen Felder bekannt.
So beschreibt die DE 29 07 591 ein Verfahren zur Messung von Feldstärken nach dem Superhet-Prinzip. Dieses Verfahren dient der Anzeige von Feldstärken auf einem Oszillographenschirm, die Elektronik des Feldstärkesensors ist von den Antennen abgesetzt. Das Verfahren entspricht dem eines Meßempfängers und ist nur zur Erfassung elektrischer Felder geeignet. Die Anordnung ist im Verhältnis zur Wellenlänge relativ groß und beeinflußt die Meßgenauigkeit negativ.

In der DE 23 18 232 wird eine Feldmeßvorrichtung für elektrische bzw. magnetische Felder beschrieben, wobei dieses Prinzip auf der Gleichrichtung des Meßsignales im Meßkopf durch Diodengleichrichtung basiert. Bei diesem Verfahren geht jedoch die Möglichkeit der Phasenmessung vollständig verloren.

Ein weiteres Verfahren wird in der DE 33 15 209 und der DE 33 15 210 beschrieben. Die dort verwendeten Nahfeldsonden zeichnen entweder magnetische oder elektrische Felder auf. Die Elektronik zu diesem Sensor befindet sich in einem nicht ausreichend abgeschirmten Gehäuse. Die Anwendung von Analogrechnern zur Auswertung ist nicht mehr zeitgemäß.

Durch die EP 0 501 169 wird ein Feldstärkemeßgerät bekannt, mit dem durch Addition bzw. Subtraktion von Teilspannungen einer Schleifenantenne, bezogen auf eine Metallfläche, der Wert für das magnetische bzw. elektrische Feld bestimmt werden kann.

Eine Schleifenantenne wird durch eine Halbschleife, die durch eine Metallfläche abgeschlossen ist, gebildet. Aufgrund des Spiegeleffektes der Metallfläche ist diese Anordnung feldtheoretisch äquivalent zu einer Schleifenantenne, die aus zwei Halbschleifen, welche durch zwei an gegenüberliegenden Seiten der Schleifenantenne angeordnete Lastwiderstände in eine erste und eine zweite Halbschleife aufgetrennt ist. Eine Schaltung zum ermitteln der Feldstärken ist in einem abgeschirmten Teilraum angeordnet.
Nachteilig hierbei ist, daß das Verfahren vom Aufbau her stark unsymmetrisch ist und eine Realisierung als dreidimensional arbeitender Sensor aufgrund dieser Unsymmetrie nicht bzw. nur stark fehlerbehaftet möglich ist. Zusätzlich wird kein echter Poynting-Vector gemessen.

In einem Bericht der Physikalisch Technischen Bundesanstalt, PTB-Bericht PTB-E-45 Braunschweig, Dezember 1992 wird ein Feldstärkemeßgerät für elektrische und magnetische Felder basierend auf den Erkenntnissen gemäß der EP 0 501 169 beschrieben, bei welchem sich die Elektronik zu dem Sensor im Inneren der Schleifenantenne befindet. Durch die geometrische Anordnung des Elektronikgehäuses werden die zu messenden Felder unzulässig beeinflußt. Die Phasenmessung erfolgt zwischen einem nicht mit dem zu messenden Feld korrelierenden Referenzsignal. Schwebung zwischen beiden führen zu nicht reproduzierbaren Ergebnissen.

Der Erfindung liegt daher die Aufgabe zugrunde, einen Sensor zur Feldstärkemessung zu schaffen, mit welchem gleichzeitig die Messung von elektrischen und magnetischen Feldern möglich ist und der Phasenwinkel zwischen den einzelnen elektrischen und magnetischen Feldkomponenten und damit der Poynting-Vector bestimmt werden kann, wobei der Sensor einfach und preiswert herstellbar ist und genaue, unverfälschte und reproduzierbare Meßergebnisse liefert.
Diese Aufgabe wird erfindungsgemäß gelöst durch die Merkmale im kennzeichnenden Teil des Anspruches 1 in Verbindung mit den Merkmalen im Oberbegriff.
Zweckmäßige Ausgestaltungen der Erfindung sind in den Unteransprüchen enthalten.

Ein wesentlicher Vorteil der Erfindung besteht darin, daß der Sensor dreidimensional arbeitet und die gleichzeitige Messung von magnetischen und elektrischen Feldern gestattet, indem er aus einem Meßkopf und einem Elektronik- und Energieversorgungsblock besteht, wobei der Meßkopf als ein auf der Spitze stehender Würfel ausgebildet ist und an allen Würfelflächen Leitungen derart angeordnet sind, daß die an den sich gegenüberliegenden Würfelflächen angeordneten Leitungen jeweils ein Paar bilden.
Die Meßwerterfassung basiert dabei auf der Einkopplung der Feldgrößen in impedanzrichtig abgeschlossene Leitungen, welche auf Antennenkörpern angeordnet sein können. Die Antennenkörper sind zu ihren benachbarten Antennenkörpern und damit die Leitungen an den jeweiligen Würfelflächen um 90° versetzt angeordnet, wobei die Befestigungsgrundfläche der Antennenkörper parallel zu den Kanten der Würfelfläche verläuft.

Der Sensor weist als weitere vorteilhafte Besonderheit einen kompakten, handlichen Aufbau auf, der eine hohe Flexibilität bei der Anwendung gestattet und zusätzliche, herkömmliche Meßgeräte zum Betreiben der Anordnung nicht erforderlich macht, wobei der Würfel ein Hohlkörper ist und aus Ferritmaterial besteht und der Elektronik- und Energieversorgungsblock ein Gehäuse aus Aluminium aufweist, welches innen und/oder außen mit Ferritmaterial beschichtet und in welchem die Meßelektronik und die Stromversorgung angeordnet ist.
Die Energieversorgung erfolgt durch einen eigenen mit Druckluft betriebenen Generator und macht aufwendiges Wechseln von Batterien oder Akkumulatoren überflüssig. Das Versagen der Meßeinrichtung während einer Messung wird hierdurch sicher vermieden, kostspielige Wiederholungen von Messungen werden überflüssig. Einer Verfälschung der Meßwerte durch elektrische Zuleitungen wird vorgebeugt.

Der Aufbau des Sensors gestattet unterschiedliche Betriebsarten hinsichtlich der durchzuführenden Messungen, als auch des grundsätzlichen Verfahrens. Letzteres bedeutet die Möglichkeit zum off-line/on-line-Betrieb. Im off-line Modus werden die Daten im Inneren des Sensors zur späteren Auswertung zwischengespeichert, während der on-line Modus eine unmittelbare Datenübertragung aller Meßwerte ermöglicht. Eine Panorama-Messung ermöglicht dem Anwender einen ersten Überblick über den zu messenden Frequenzbereich. Die Meßelektronik weist hierzu Mittel zur Verstärkung, Hochfrequenzaufbereitung, Analog-Digital-Wandlung, Frequenzerzeugung, Steuerung und Kühlung auf.

Der Sensor arbeitet nach dem Superhet-Prinzip. Hierdurch wird eine schmalbandige Messung der Feldkomponenten ermöglicht. Die erforderliche Referenzfrequenz wird durch einen eingebauten Synthesizer erzeugt. Ein externes Gerät zur Erzeugung dieser notwendigen Referenzfrequenz ist nicht erforderlich.

Ein Tarnschirm aus speziellem Ferritmaterial macht das Gerät für elektrische und magnetische Felder unsichtbar. Hierdurch wird eine Beeinflussung der zu messenden Felder weitgehend vermieden und ein Einfluß auf die Meßergebnisse verringert.
Das Gerät verfügt über zwei identische Meßkanäle. Durch einen 6:2 Signalmultiplexer können die einzelnen Meßsignale auf die entsprechenden Meßkanäle geschaltet werden. Hierdurch wird die Möglichkeit geschaffen, alle Eingangssignale miteinander zu verknüpfen. Ebenso resultiert daraus auch die Möglichkeit, den Phasenwinkel zwischen den einzelnen elektrischen und magnetischen Feldkomponenten zu bestimmen. Dies ist für die Bestimmung des Poynting-Vectors erforderlich.

Die Erfindung soll nachstehend anhand von in den Figuren dargestellten Ausführungsbeispielen näher erläutert werden.

Es zeigen:
- Fig. 1: Eine schematische Darstellung des Sensors mit Meßkopf und Elektronik- und Energieversorgungsblock in teilweiser Schnittdarstellung;
- Fig. 2: Ein Blockschaltbild der Elektronik

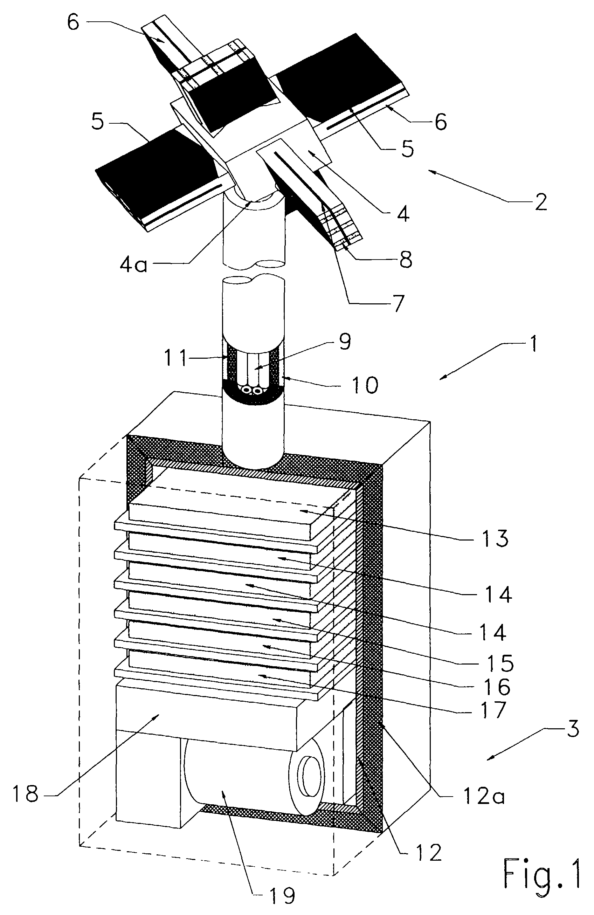

Der Sensor 1 besteht, wie der Figur 1 zu entnehmen ist, aus zwei Funktionseinheiten, dem Meßkopf 2 und dem Elektronik- und Energieversorgungsblock 3 und arbeitet im Frequenzbereich von ca. 150 KHz bis ca. 2,5 GHz und mit einer Amplitude zwischen einigen µV bis hin zu eingien hundert Volt/m.
Der Meßkopf 2 ist ein auf der Spitze 4a stehender Würfel 4, an dessen sechs Würfelflächen sich jeweils eine Leitung 5 befindet. Der Würfel 4 selbst ist als Hohlkörper ausgebildet und aus einem speziellen Ferritmaterial gefertigt. Durch diese Anordnung wird die getrennte Auswertbarkeit aller Feldsignale ermöglicht.
Die Leitungen 5 sind auf den Würfelflächen so angeordnet, daß eine Einkopplung aller drei Feldkomponenten, sowohl des magnetischen als auch des elektrischen Feldes möglich ist. Hierdurch kann das Feld mit allen drei Komponenten ohne Veränderung der Sensorposition erfaßt werden. Jeweils zwei gegenüberliegende Leitungen 5 bilden ein Paar. Im vorliegenden Ausführungsbeispiel sind die Leitungen 5 als Streifenleiter ausgebildet und auf Antennenkörpern 6 angeordnet, wobei die Antennenkörper 6 zu ihren benachbarten Antennenkörpern jeweils um 90° versetzt an den Würfelflächen befestigt sind. Die Befestigungsgrundfläche der Antennenkörper 6 verläuft parallel zu den Kanten der Würfelfläche.
An der dem Würfel 4 abgewandten Seite sind die Leitungen 5 mit Widerständen 8 zum Mittelleiter 7 hin impedanzrichtig abgeschlossen. Mit Hilfe der innerhalb des Würfels 4 über die Außenleiter der Koaxialleitungen 9 mit Masse verbundenen Mitteilleiter 7 und mit Hilfe der im Meßkopf 2 zwischen die Leitungen 5 und die Koaxialleitungen 9 geschalteten Baluns werden Gleichtaktspannungen unterdrückt.

Gemäß einer weiteren Ausführungsvariante sind die Leitungen 5 aus parallel angeordneten Runddrähten ausgebildet.

Über ein mit Ferritschlauch 11 elektromagnetisch getarntes Rohr 10 werden die Einzelsignale der Meßelektronik in dem Elektronik- und Energieversorgungsblock 3 zugeführt.
Der Elektronik- und Energieversorgungsblock 3 besitzt ein außen mit Ferritmaterial 12a belegtes Gehäuse 12 aus Aluminium. Hierin ist die gesamte Elektronik, bestehend aus diversen Hochfrequenzverstärkern 13, Hochfrequenz- Aufbereitungsmodulen 14, AD-Wandlern 15, Frequenzerzeugern 16, Steuereinheit 17 und Kühlung 18, sowie ein druckluftbetriebener Generator 19 zur Stromversorgung der Komponenten, untergebracht.

Nachfolgend soll die Inbetriebnahme und die Funktionsweise des Sensors 1 noch kurz erläutert werden. Nach den zur Inbetriebnahme erforderlichen Vorbereitungen wird der Generator 19 mit Druckluft versorgt. Hierdurch wird über die eingebaute Turbine die zum Betrieb erforderliche Energie produziert. Die eingebaute Steuerung 17 startet, initalisiert das System und erwartet Anweisungen vom Benutzer über Optolink. Dieser wählt eines der vorgegebenen Meßprogramme aus oder übermittelt neue Daten für ein anwenderspezifisches Meßprogramm.

Nach dieser Vorbereitung ist das System zur Messung der Daten nach Meßprogramm bereit. Der Anwender startet das Programm per Optolink und der Sensor 1 beginnt mit der Abarbeitung des Meßprogrammes. In Abhängigkeit von der gewählten Betriebsart übermittelt der Sensor 1 die Daten per Optolink sofort an die Auswertestation des Anwenders oder sammelt die gemessenen Werte im internen Datenspeicher, um die Daten komprimiert an den Anwender zu übermitteln.

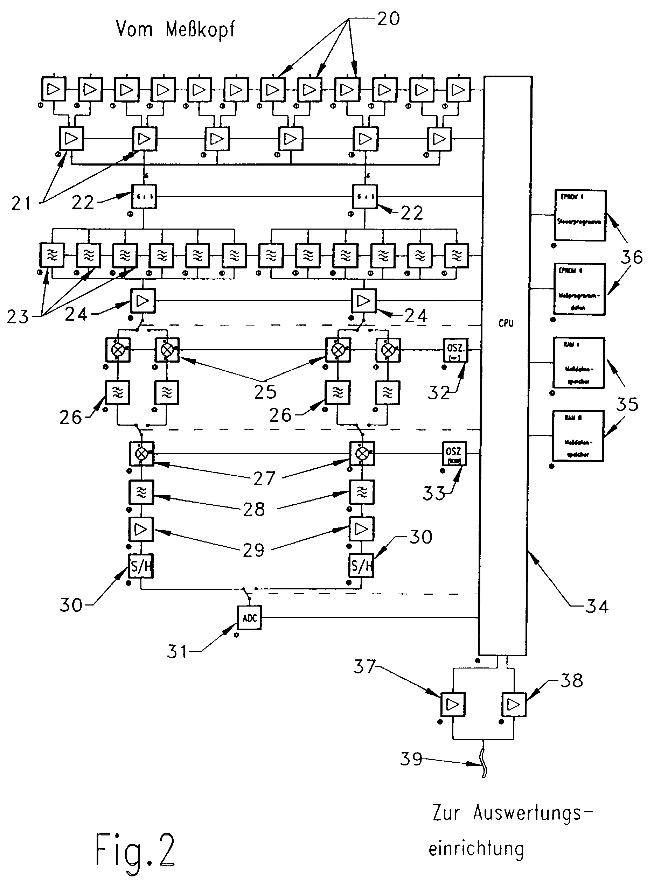

Die Arbeitsweise der zwischen Meßkopf (2) und Auswerteeinrichtung angeordneten Elektronik ist in Fig. 2 dargestellt.

Die Eingangssignale des Meßkopfes 2 gelangen in die Eingangstrennverstärker 20 und werden entkoppelt den Summenverstärkern 21 zugeführt. Diese ermitteln die Beträge der Feldkomponentenanteile für das elektrische und magnetische Feld. Über die nachgeschalteten Multiplexer 22 kann für jeden Meßkanal einzeln ausgewählt werden, welches Signal ausgewertet werden soll. In einer nachfolgenden Bank von Bereichsfiltern 23 wird eine Grobselektierung des Signales vorgenommen. Ein nachfolgender Trennverstärker 24 entkoppelt die Signale und gleicht Verluste durch die Bereichsfilter 23 aus. Über den ersten Mischer 25 in Verbindung mit dem Frequenzsynthesizer 32 wird die zu messende Frequenz selektiert. Über das erste ZF-Filter 26 gelangt das Meßsignal in den zweiten Mischer 27, der in Verbindung mit dem Referenzoszillator 33 eine Frequenzumsetzung vornimmt. Über das nachfolgende zweite ZF-Filter 28 und einen Ausgangstrennverstärker 29 wird das Signal einer Sample & Hold-Schaltung 30 zugeführt, um anschließend durch den Analog-Digital-Converter 31 digitalisiert zu werden. Diese Werte werden vom Mikroprozessor 34 erfaßt und im RAM 35 als Datenwort abgelegt. Die Programmierung für die Ablaufsteuerung sowie Tabellen für Meßprogramme werden im EPROM 36 abgelegt. Die Kommunikation mit der Außenwelt geschieht über ein Lichtwellenleiter 39. Die Kopplung des Systems erfolgt über die Sendestufe 37 und die Empfangsstufe 38.

Die Erfassung der Feldkomponenten in den Streifenleitungen erfolgt gemäß der traditionellen Prinzipien der HF-Technik sowie deren Reziprozität.

Die Erfindung ist nicht auf die hier beschriebenen Ausführungsbeispiele beschränkt. Vielmehr ist es möglich, durch Kombination der genannten Mittel und Merkmale weitere Ausführungsvarianten zu realisieren, ohne den Rahmen der Erfindung zu verlassen.

### Bezugszeichenliste

- 1: Sensor
- 2: Meßkopf
- 3: Elektronik- und Energieversorgungsblock
- 4: Würfel
- 4a: Spitze
- 5: Leitungen
- 6: Antennenkörper
- 7: Mitteilleiter
- 8: Widerstände
- 9: Koaxialleitungen
- 10: Rohr
- 11: Ferritschlauch
- 12: Gehäuse
- 12a: Ferritmaterial
- 13: Verstärkung
- 14: HF-Aufbereitung
- 15: AD-Wandlung
- 16: Frequenzerzeugung
- 17: Steuerung
- 18: Kühlung
- 19: Generator
- 20: Eingangstrennverstärker
- 21: Summenverstärker
- 22: 6 zu 1 Multiplexer
- 23: Bereichsfilter
- 24: Trennverstärker
- 25: 1. Mischer
- 26: 1. ZF-Filter
- 27: 2. Mischer
- 28: 2. ZF-Filter
- 29: Ausgangstrennverstärker
- 30: Sample & Hold-Schaltung
- 31: Analog-Digital-Converter
- 32: Frequenzsynthesizer
- 33: Referenzoszillator
- 34: Mikroprozessor
- 35: RAM
- 36: EPROM
- 37: Sendestufe
- 38: Empfangsstufe
- 39: Lichtwellenleiter

## Patentansprüche

1. Sensor zur Feldstärkemessung von magnetischen und/oder elektrischen Feldern nach dem Superhet-Prinzip unter Verwendung von Antennen,
dadurch gekennzeichnet,
daß der Sensor (1) aus einem Meßkopf (2) und einem Elektronik- und Energieversorgungsblock (3) besteht, wobei der Meßkopf (2) als ein auf der Spitze (4a) stehender Würfel (4) ausgebildet ist und an allen Würfelflächen impedanzrichtig abgeschlossene Leitungen (5) derart angeordnet sind, daß die an den sich gegenüberliegenden Würfelflächen angeordneten Leitungen (5) jeweils ein Paar bilden.

2. Sensor nach Anspruch 1,
dadurch gekennzeichnet,
daß die Leitungen (5) als Streifenleitungen ausgebildet sind.

3. Sensor nach Anspruch 1,
dadurch gekennzeichnet,
daß die Leitungen (5) aus Runddrähten ausgebildet sind.

4. Sensor nach Anspruch 2 oder 3
dadurch gekennzeichnet,
daß die Leitungen (5) um einen Mittelleiter (7) zu einem Dreileitersystem ergänzt sind und dieser Mittelleiter (7) innerhalb des Würfels (4) über die Außenleiter der Koaxialleitungen (9) mit Masse verbunden wird und die Verbindung der Leitungen (5) mit den Inneleitern der Koaxialleitungen (9) über Baluns erfolgt.

5. Sensor nach Anspruch 1,
dadurch gekennzeichnet,
daß die Leitungen (5) auf Antennenkörpern (6) angeordnet sind.

6. Sensor nach Anspruch 1 oder 5,
dadurch gekennzeichnet,
daß die Antennenkörper (6) zu ihren benachbarten Antennenkörpern um 90° versetzt angeordnet sind.

7. Sensor nach Anspruch 5 oder 6,
dadurch gekennzeichnet,
daß die Befestigungsgrundfläche der Antennenkörper (6) parallel zu den Kanten der Würfelfläche angeordnet ist.

8. Sensor nach mindestens einem der voranstehenden Ansprüche,
dadurch gekennzeichnet,
daß die Antennenkörper (6) an ihren, der Befestigungsgrundfläche zugewandten Ende keilförmig zulaufend und die Leitungen (5) an diesem Ende spitz zulaufend ausgebildet sind.

9. Sensor nach Anspruch 4,
dadurch gekennzeichnet,
daß die Leitungen (5) an der dem Würfel (4) abgewandten Seite mit Widerständen (8) impedanzrichtig zum Mitteilleiter (7) hin abgeschlossen sind.

10. Sensor nach Anspruch 1,
dadurch gekennzeichnet,
daß der Würfel (4) ein Hohlkörper ist und aus Ferritmaterial besteht.

11. Sensor nach Anspruch 1,
dadurch gekennzeichnet,
daß der Meßkopf (2) mit dem Elektronik- und Energieversorgungsblock (3) über Koaxialleitungen (9) verbunden ist.

12. Sensor nach Anspruch 11,
dadurch gekennzeichnet,
daß die Koaxialleitungen (9) in einem Rohr (10) aus Aluminium mit einer Ferritinnenauskleidung und/oder einer Ferritaußenbeschichtung geführt werden.

13. Sensor nach Anspruch 12,
dadurch gekennzeichnet,
daß die Ferritinnenauskleidung ein Ferritschlauch (11) ist.

14. Sensor nach Anspruch 1,
dadurch gekennzeichnet,
daß der Elektronik- und Energieversorgungsblock (3) ein Gehäuse (12) aus Aluminium, welches innen und/oder außen mit Ferritmaterial (12a) beschichtet ist, aufweist, in welchem die Meßelektronik und die Stromversorgung angeordnet ist.

15. Sensor nach Anspruch 1 oder 14,
dadurch gekennzeichnet,
daß die Meßelektronik Mittel zur Verstärkung (13), HF-Aufbereitung (14), AD-Wandlung (15), Frequenzerzeugung (16), Steuerung (17) und Kühlung (18) aufweist.

16. Sensor nach Anspruch 1 oder 14,
dadurch gekennzeichnet,
daß die Stromversorgung ein mittels Druckluft angetriebener Generator (19) ist.

17. Sensor nach Anspruch 3,
dadurch gekennzeichnet,
daß die Runddrähte parallel angeordnet sind.
